# EUROPEAN PATENT APPLICATION

(11) **EP 1 500 450 A1**
(43) Date of publication of application: **26.01.2005**
(21) Application number: 03102289.0
(22) Date of filing: 24.07.2003
(51) Int. Cl.: B22F 7/00, F28F 13/00, B22F 3/11

(54) **Method for joining a metal foam to a metal part**

(71) Applicant: EFOAM S.A., 2930 Luxembourg (LU)
(72) Inventor: Kuhn, Marc, 4397, Pontpierre (LU)
(74) Representative: Kihn, Pierre Emile Joseph

(57) **Abstract**

A method for joining a metal foam to a metal part comprises the following steps:
providing a metal part (14);
providing an open cell metal foam (10);
applying the metal foam (10) onto a surface (12) of the metal part (14);
depositing e.g. by thermal decomposition of nickel carbonyl a metal onto the metal foam (10) and the surface (12) of the metal part (14) through the metal foam (10) in a quantity sufficient to join the metal foam to the metal part.

## Description

### FIELD OF THE INVENTION

The present invention generally relates to a method for joining a metal foam to a metal part.

### BACKGROUND OF THE INVENTION

In the past decade, metallic foams have attracted increasing interest in many industrial fields. Indeed, various production routes of metal foams have been explored and metal foams are now currently used in electric, electronic, heat management or chemical applications. For example, metal foams are used in battery electrodes, cooling structures for heat-exchangers or semiconductor chips, electromagnetic screens and catalyst support. In a number of these applications, it is necessary to join the metal foam to a solid metal part.

### OBJECT OF THE INVENTION

The object of the present invention is to provide a method for joining a metal foam to a metal part. This is achieved by a method as claimed in claim 1.

### SUMMARY OF THE INVENTION

According to the present invention, a method for joining a metal foam to a metal part comprises the following steps:
providing a metal part;
providing an open cell metal foam;
applying the metal foam onto a surface of the metal part;
depositing a metal onto the metal foam and the surface of the metal part, through the metal foam, in a quantity sufficient to join the metal foam to the metal part.

The present method allows joining a variety of metal foams to a metal part. The term "metal foam" herein means any metallic open cell structures, not only truly cellular material, and thus also includes porous materials such as woven or non-woven metallic structures. Some porosity of the metal foam is required for the present method, since the joining metal has to penetrate into the foam via its pores to reach the interface with the metal part. Therefore, the metal foams to be joined to a metal part according to the present method preferably have a mainly open cell structure (i.e. with a majority of open cells).

It will be appreciated that, in the present method, the metal foam is first applied onto the metal part to which it is to be joined, and the joining metal is provided thereafter, through the metal foam. The present method thus takes advantage of the porosity of the open cell metal foam to achieve the deposition of the joining metal. Since the joining material is only provided after the metal foam has been applied onto the part, both elements can easily be handled, which more particularly facilitates the positioning of the foam on the metal part.

Furthermore, the joining metal also normally deposits onto the surfaces of the metal foam, while travelling therethrough, so that a coating is also formed on the metal foam. In case a corrosion resistant metal, e.g. nickel, is used as joining metal, it is thus possible to simultaneously provide an anti-corrosive layer onto the metal foam and metal part surface.

Depending on the technology used for the metal deposition step, it is possible to promote the deposition of metal at the foam/part interface, so that the portion of the foam facing the metal part can be strongly embedded in the metal deposited on surface of the metal part. Increasing the thickness of the joining metal at the interface permits increasing the mechanical link between metal and foam. In addition, it provides a structure that is favourable to thermal conduction between the metal part and the foam, which is interesting for heat-exchange applications.

Different techniques can be used to achieve the metal deposition for joining the metal foam to the metal part. It is however preferably carried out by techniques which allow forming elemental metal deposits onto a substrate at temperatures well below the melting point of this metal. The joining metal should preferably be deposited in a quantity sufficient to form a metal deposit on the metal part surface embedding the end portion of the arms of the foam facing the metal part.

In a preferred embodiment, the metal deposition step comprises bringing the assembly of the metal foam and the metal part into contact with a process gas comprising a metallic compound, and heating the assembly to a temperature at which the metallic compound decomposes in contact with the heated surfaces to form an elemental metal deposit on the heated surfaces. The gaseous metallic compound will easily penetrate the pores of the metal foam, through the metal foam, thereby providing a substantially continuous coating. A particularly preferred gas for this chemical vapour deposition (CVD) is nickel carbonyl gas. In such a case, the foam/part assembly is heated to a temperature in the range of 100 to 300°C, more preferably between 120 and 180°C.

In another preferred embodiment, the metal deposition is carried out by electroless plating. For example, the assembly of the metal foam and metal part can be immersed in an electroless nickel or copper plating bath. Electroless plating is a technique that produces uniform metallic coatings, even with complex shapes having deep recesses.

A further alternative for depositing the joining metal is electrolysis. In such a case, the assembly of the metal foam and metal part is immersed in an electroplating bath and a cathodic potential is applied to the assembly, thereby depositing the joining metal due to reduction.

A variety of metals can be used as joining metal. Two preferred metals are nickel and copper. Copper is preferred for its excellent thermal conductivity whereas nickel may be preferred if corrosion resistance is of higher importance. To benefit from the properties of one or more metals, it is however possible to form a second metal deposit over the joining metal deposit, using e.g. the same deposition technique if applicable. For example, in the case of heat-exchange applications, a substantial copper deposit can firstly be formed to join the metal foam to the metal part, which also confers good thermal conductivity to the joining metal deposit. Then, a thin nickel deposit can be formed over the copper deposit to provide an anti-corrosion layer. Electroless plating is particularly well suited for such a method where two (or more) successive metal deposits are to be formed on the metal/part assembly.

Heating of the foam/part assembly can be done by a variety of methods, depending on the metal deposition technique employed and assembly geometry, and namely by conduction, radiation, inductance or resistance heating. It will be noted that the heating of the assembly is preferably carried out in such a way as to create a temperature gradient, which decreases from the metal part toward the metal foam. Since the kinetics of most chemical processes, in particular CVD and electroless plating, are generally temperature dependent, this shall permit to produce a thicker metal deposit at the foam/part interface. Such a temperature gradient can be obtained by heating the assembly in such a way that the foam is heated by the metal part due to heat conduction.

Advantageously, the present method comprises, after said metal deposition step, a further step of subjecting the assembly of the metal foam and metal part to a thermal treatment in order to improve the mechanical properties of the metal deposit. Such a treatment is preferably carried out in a non-oxidising or reducing atmosphere.

Preferably, the metal foam is applied onto the metal part in such a way as to be in intimate contact therewith. Wires, clamps, spot-welding or other known techniques may be used for this purpose.

The metal part can be made of a variety of metals, such as e.g. stainless steel, or nickel, copper or aluminium, or an alloy based on one of these metals. It will however be understood that the metals of the metal part, and in fact also of the metal foam, will generally depend on the applications they are intended for.

The present method is particularly well suited for joining a metal foam to a metal part in view of the manufacture of devices for heat management (heat exchangers, cooling devices...). In such a case, the metal foam should preferably be made of a metal having good thermal conductivity, such as e.g. copper or copper alloy, nickel or nickel alloy or aluminium or aluminium alloy. Copper is however preferred for its excellent heat conductivity.

The present method thus allows manufacturing of heat-exchangers such as e.g. foam cladded pipes. In such a case, the metal part is a metal pipe and the metal foam is joined to the external surface of the pipe. The metal foam is preferably a strip of foam that is helicoidally wound around the pipe.

Still in conjunction with heat-exchange applications, the metal foam shall preferably have a porosity in the range of 60 to 90% with 30 to 100 pores per inch (ppi). The measurement of porosity is linear; it corresponds to the number of unit cells (pores) that are counted along a line of one inch in length. Furthermore, the metal foam may be a copper foam having a specific weight in the range of 1 000 to 3 000 g/m², more preferably in the range of 1 750 to 2 250 g/m², most preferably about 2 000 g/m².

It will be noted that the weight of each metal in the foams are expressed herein with reference to their "specific weight". This term is herein understood as the mass of metal per apparent unit area of the metal foam. For example, if the specific weight of a given metal, e.g. copper, in a flat metal foam strip is 1 500 g/m², it means that a piece of this metal foam strip having apparent external dimensions of 1 m x 2 m will contain 3 000 g of copper.

Metal foams can be obtained by a variety of methods, which differ in the state of matter in which the metal is processed. In the present method, electrolytically produced metal foams are however preferred for their reproducibility and for the economics of such processes. In a typical electrolytic process, a porous support such as a polymer foam is rendered electrically conductive, and this porous support is then passed through an electroplating bath to deposit a desired thickness of metal on the porous support. If desired, the initial porous substrate can then be removed by a thermal treatment. Such a process is highly reproducible, as the characteristics of the polymer foam are reproduced rather closely, and the wall thickness of the cells can precisely be controlled during electrolysis. In this connection, particularly interesting polymer foams are "reticulated" polyurethane foams, since they have very regular and highly porous structures. Electrodepositing a metal, e.g. copper, on such a polyurethane foam thus leads to an open cell metal foam having a highly reproducible structure, and very good thermal conductivity.

### BRIEF DESCRIPTION OF THE DRAWINGS

The present invention will now be described, by way of example, with reference to the accompanying drawings, in which:
- FIG. 1:: is a sketch partially showing a pipe to the external surface of which a copper foam has been joined by means of a preferred embodiment of the method according to the present invention; and
- FIG. 2:: is a sketch illustrating the profile of the metal deposit at the foam/pipe interface.

### DETAILED DESCRIPTION OF A PREFERRED EMBODIMENT

A preferred embodiment of the method in accordance with the present invention will now be explained in more detail, with regard to the fabrication of a copper foam cladded metal pipe to be used as heat exchanger. Such a cooling pipe can advantageously be produced by joining a copper foam to the exterior surface of a metal pipe in accordance with the present method. For this application, the metal pipe can be made of stainless steel, copper, nickel or aluminium, or an alloy comprising one of these metals. The use of a copper foam is preferred for its excellent thermal conductivity. The joining metal is nickel, which is deposited by chemical vapour deposition.

### 1. Metal foam production

The open cell copper foam is preferably prepared by an electrolytic technique. This can be done by electrodepositing copper on a non-metallic foam or porous substrate in an aqueous electrolytic copper bath. A prerequisite for this method is that the porous substrate has sufficient electrical conductivity for electrodeposition. If required, various techniques, among which chemical treatment or vacuum deposition, can be used to increase the substrate conductivity. The electrically conductive porous structure is then subjected to electro-deposition to form thereon a copper layer of desired thickness. More preferably, the copper foam is produced by electro-deposition in a cylindrical electrolytic cell, as described in WO 02/22914. The initial porous substrate can generally be removed by thermal treatment.

The initial porous substrate preferably is a reticulated polyurethane foam, which has a fine and regular open cell structure. Such a polyurethane foam can be easily produced and processed in strip foam.

In the present embodiment, the polyurethane foam is firstly pre-metallized by vacuum deposition. A very thin layer of copper is formed, preferably in an amount of e.g. 3 to 10 g/m² for a 2 mm thick strip of polyurethane foam. The premetallized polymer foam is then passed through a cylindrical electroplating cell to deposit a desired thickness of copper, thereby obtaining the metal foam. The electroplating parameters are preferably adjusted to form a metal foam with a specific weight of copper in the range of 1 000 to 3 000 g/m², more preferably in the range of 1 750 to 2 250 g/m², most preferably about 2 000 g/m².

Such heavy copper foams are preferred for heat management applications as they capable of transmitting large amounts of heat due to the excellent thermal conductivity of copper.

For productivity reasons, the initial polyurethane foam is preferably a coiled strip of polyurethane foam, which can be subjected to continuous pre-metallizing and electroplating. Copper foams are thus generally available in coiled strip form.

### 2. Production of the copper foam cladded pipe

According to the present method, the metal foam is applied to the external surface of the metal part to which it is to be joined. Accordingly, in the present embodiment, a strip of metal foam is applied to the external surface of the metal pipe. A joining metal is then deposited onto the metal foam and the pipe surface, through the metal foam. In the present embodiment, the joining metal is nickel and is deposited by chemical vapour deposition using nickel carbonyl gas.

### 2.1 Nickel carbonyl gas

Nickel carbonyl is basically produced by reacting Ni + 4CO → Ni(CO)₄. Nickel carbonyl is a gas which decomposes into nickel and carbon monoxide when heated to temperatures above about 100 to 120 °C. One can therefore coat a substrate by letting a stream of nickel carbonyl gas flow onto its surface at such temperatures. The nickel formed during decomposition will accumulate on the substrate surface, thus creating a metallic coating.

### 2.2 Foam to pipe joining

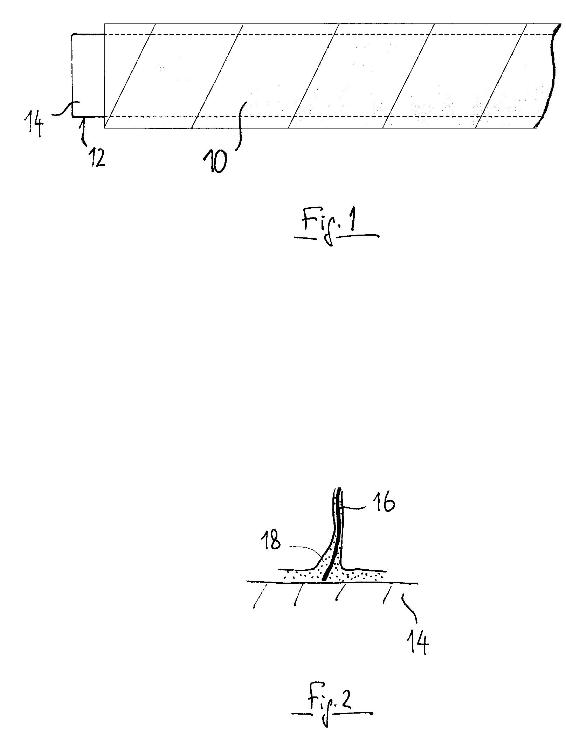

In order to manufacture a metal foam cladded pipe, the metal foam is preferably wound around the pipe in such a way as to be in intimate contact therewith. This is shown in Fig.1, which schematically depicts a strip of copper foam 10 wound around the external surface 12 of a metal pipe 14. The strip of foam 10 is helicoidally wound―in a single layer―around the pipe 14 to substantially cover its external surface 12. The end portions of the pipe may remain uncovered for ease of connection.

The subsequent nickel deposition step is then carried out by CVD using nickel carbonyl gas. The pipe/foam assembly is introduced in a deposition chamber having an atmosphere of nickel carbonyl Ni(CO)₄, and heated therein to a decomposition temperature of nickel carbonyl, preferably about 110°C to 180°C.. The nickel carbonyl decomposes at the heated surfaces of the foam and pipe to form elemental nickel deposits and carbon monoxide. Optionally, H₂S gas or another catalyst may be added to the deposition chamber to promote nickel plating. In the deposition chamber, the flow of nickel carbonyl is preferably controlled so that it flows throughout the foam and that relatively homogeneous concentrations are maintained.

Nickel accumulates on the pipe's external surface and the copper foam, and the deposition is continued until a sufficient quantity of nickel has been deposited to embed a majority of the foam's arms in the nickel deposits at the interface.

Furthermore, nickel deposition is advantageously controlled in such a way as to deposit more nickel at the foam/pipe interface than onto the foam. This can be achieved by creating a temperature gradient inside the foam/pipe assembly, which decreases from pipe to foam. Such a temperature gradient can be obtained by heating the pipe only, so that the foam is heated by conduction of heat from the pipe to the foam (which is in intimate contact with the pipe).

When joining the metal foam to a pipe, such a heating can be achieved by circulating a hot fluid through the pipe. When joining a metal foam to a platelike metal substrate, a temperature gradient can be obtained by e.g. heating the substrate from the side opposed to the side in contact with the metal foam.

Since the nickel deposition rate is function of temperature, a greater quantity of nickel will thus deposit at the foam/pipe interface. This particular nickel deposit profile is illustrated in Fig.2, wherein reference sign 16 indicates an arm of the foam embedded in a nickel deposit 18 at the interface with the pipe 14. As can be seen, the thickness of the nickel deposit 18 decreases in a direction moving away from the pipe 14.

The use of nickel carbonyl gas for forming the joining metal deposit is considered to be particularly interesting since, being in gaseous state, nickel carbonyl will easily penetrate through the foam down to the interface, but will also reach every recess in the foam structure. This ensures a coating of substantially the whole copper foam surface and a strong embedding of the copper foam in nickel at the foam/pipe interface.

It will be appreciated that the use of nickel as joining metal in the present embodiment permits to achieve several functions. Firstly, the nickel deposit provides the joining between the copper foam and the metal pipe. Secondly, since nickel also deposits over the surface of the copper foam, it forms an anti-corrosive layer on the copper foam. Thirdly, the particular profile of the nickel deposit―which is thicker at the interface―results in an improved mechanical strength of the joining. In addition, this structure is considered to be particularly favourable to thermal exchanges between the copper foam and the supporting metal pipe.

### 2.3 Thermal treatment

Upon joining of the copper foam to the pipe, the copper foam cladded pipe preferably undergoes a thermal treatment to improve the mechanical characteristics of the nickel coating.

### 3 Remarks

It is to be noted that the nickel deposition could alternatively be carried out by electroless plating or electroplating.

Electroless plating is preferred as this technique permits the formation of uniform coatings, even with complex shapes with recess (as in foams). Furthermore, the deposition rate is also temperature dependent, so that a thicker nickel coating can be obtained at the foam/pipe interface when creating a temperature gradient in the assembly.

Another advantageous aspect of electroless plating is that it allows the deposition of nickel and copper. This deposition technique thus permits to firstly form a joining copper deposit to strongly join the metal foam to the metal pipe and to secondly form a protective nickel layer on the copper deposit. This is of particular interest in the manufacture of heat-exchangers, since the metal foam can be embedded in a thick copper deposit, which provides good thermal conduction, and the overlying nickel layer provides an anti-corrosive layer.

Electroplating is preferably to be used with foams of large cell size and porosity.

## Claims

1. A method for joining a metal foam to a metal part comprising the following steps:
providing a metal part;
providing an open cell metal foam;
applying said metal foam onto a surface of said metal part;
depositing a metal onto said metal foam and said surface of said metal part through said metal foam in a quantity sufficient to join said metal foam to said metal part.

2. The method according to claim 1, wherein said metal deposition step comprises bringing the assembly of said metal foam and said metal part into contact with a process gas comprising a metallic compound, and heating said assembly to a temperature at which said metallic compound decomposes in contact with the heated surfaces to form a metallic deposit on said heated surfaces.

3. The method according to claim 2, wherein said process gas comprises nickel carbonyl and said assembly of said metal foam and metal part is heated to a temperature in the range of 100 to 300°C, preferably 120 to 180°C.

4. The method according to claim 1, wherein said metal deposition step is carried out by electroless plating.

5. The method according to claim 4, wherein said assembly of said metal foam and metal part is immersed in an electroless nickel or copper plating bath.

6. The method according to any one of the preceding claims, wherein said assembly of said metal foam and metal part is heated by conduction, radiation, inductance or resistance heating.

7. The method according to any one of the preceding claims, wherein said heating of said assembly of said metal foam and metal part is carried out in such a way as to produce a temperature gradient, which decreases from the metal part toward the metal foam.

8. The method according to claim 7, wherein said heating of said assembly is carried out in such a way that said metal foam is heated by said metal part due to conduction.

9. The method according to any one of the preceding claims, comprising a further step, subsequent to said metal deposition step, of subjecting said assembly of said metal foam joined to said metal part to a thermal treatment, preferably in a non-oxidising or reducing atmosphere, in order to improve the mechanical properties of the metal deposit.

10. The method according to any one of the preceding claims, wherein, when applying said metal foam to said metal part, said metal foam is brought into intimate contact with said metal part.

11. The method according to any one of the preceding claims, wherein said metal deposited to join said metal foam to said metal part is a corrosion resistant metal, preferably nickel.

12. The method according to any one of the preceding claims, wherein said metal deposited to join said metal foam to said metal part has a good thermal conductivity, said joining metal being preferably copper.

13. The method according to any one of the preceding claims, wherein said metal part is made of nickel or nickel alloy, copper or copper alloy, aluminium or aluminium alloy, or stainless steel.

14. The method according to any one of the preceding claims, wherein said metal foam is made of nickel or nickel alloy, copper or copper alloy, or aluminium or aluminium alloy.

15. The method according to claim 14, wherein said metal foam is a copper foam having a specific weight in the range of 1 000 to 3 000 g/m², more preferably in the range of 1 750 to 2 250 g/m², most preferably about 2 000 g/m².

16. The method according to any one of the preceding claims, wherein said open cell metal foam has a high porosity.

17. The method according to any one of the preceding claims, wherein said metal part is a metal pipe and said metal foam is applied onto the external surface of said metal pipe.

18. The method according to claim 17, wherein said metal foam is a strip of metal foam helicoidally wound around the pipe.

19. The method according to claim 1, wherein said metal deposition step is carried out by electroplating.

20. The method according to any one of the preceding claims, wherein a second metal deposit of a different metal is formed over the joining metal deposit.

21. A method for manufacturing a heat-exchanger, wherein a metal foam is joined to a metal part by a method as claimed in any one of the preceding claims.

22. An assembly of a metal foam and a metal part, wherein said metal foam is joined to a surface of said metal part by means of a joining metal deposited by a method as claimed in any one of claims 1 to 20.
